# EUROPEAN PATENT APPLICATION

(11) **EP 3 243 887 A1**
(43) Date of publication of application: **15.11.2017**
(21) Application number: 15877203.8
(22) Date of filing: 23.12.2015
(51) Int. Cl.: C09K 11/02

(54) **QUANTUM DOT COMPOSITE AND PHOTOELECTRIC DEVICE COMPRISING SAME**

(30) Priority: 06.01.2015 KR 20150001053
(71) Applicant: Corning Precision Materials Co., Ltd., Asan-si, Chungcheongnam-do 336-841 (KR)
(72) Inventor: LEE, Ki Yeon, Asan-si Chungcheongnam-do 336-841 (KR); OH, Yoon Seuk, Asan-si Chungcheongnam-do 336-841 (KR); LEE, Kyung Jin, Asan-si Chungcheongnam-do 336-841 (KR); YANG, Choon Bong, Asan-si Chungcheongnam-do 336-841 (KR); CHO, Seo Yeong, Asan-si Chungcheongnam-do 336-841 (KR)
(74) Representative: Gulde & Partner
(86) International application number: PCT/KR2015/014151
(87) International publication number: WO 2016/111483

(57) **Abstract**

The present invention relates to a quantum dot composite and a photoelectric device comprising the same, and more particularly, to a quantum dot composite having excellent optical characteristics, thereby improving the light efficiency of a photoelectric device, and a photoelectric device comprising the same. To this end, the present invention provides a quantum dot composite and a photoelectric device comprising the same, the quantum dot composite comprising: a matrix layer; a plurality of quantum dots dispersed inside the matrix layer; and a plurality of scattering particles dispersed inside the matrix layer in a manner of being disposed between the plurality of quantum dots, wherein the scattering particles have a hollow formed therein, thereby showing multiple refractive indices.

## Description

### BACKGROUND OF THE INVENTION

### Field of the Invention

The present invention relates to a quantum dot composite and an optoelectronic device including the same, and more particularly, to a quantum dot composite able to improve the light efficiency of an optoelectronic device due to superior optical characteristics thereof and an optoelectronic device including the same.

### Description of Related Art

A quantum dot is a nanocrystal made of semiconductor material having a diameter of about 10 nm or less, and exhibits quantum confinement characteristics. The quantum dot generates strong light in a narrow wavelength, the light being stronger than light generated from a typical fluorescent material. The radiation of the quantum dot occurs when excited electrons transit from the conduction band to the valance band. Even in the same material, the wavelength varies depending on the size of the quantum dot. The smaller the size of the quantum dot is, the shorter the wavelength of light is. It is therefore possible to produce an intended wavelength of light by adjusting the size of the quantum dot.

Methods of forming nanocrystal quantum dots include vapor deposition, such as metal organic chemical vapor deposition (MOCVD) and molecular beam epitaxy (MBE), and chemical wet processing.

The chemical wet processing is a method of controlling the growth of a crystal of a quantum dot by coordinate-boning an organic solvent onto the surface of the crystal such that the organic solvent acts as a dispersant. The chemical wet processing is simpler than the vapor deposition, such as MOCVD and MBE, and can adjust the uniformity of the size and shape of a nanocrystal through an inexpensive process.

Quantum dots manufactured through the above-described method are used in a variety of fields, such as biomedical images, photoelectric cell devices, light-emitting devices, memory, and display devices, due to unique physical properties thereof, such as a nanometer-scale size, a size-adjustable optical characteristic, high light stability, and a wide absorption spectrum.

Quantum dots are mixed into typical polymer in the shape of a sheet, which is applied to a variety of fields.

In the related art, a scattering agent, such as titanium oxide, aluminum oxide, barium titanate, or silicon dioxide, is added in order to obtain high light efficiency. However, the addition of the scattering agent alone has a limited ability to improve light efficiency.

The information disclosed in the Background of the Invention section is provided only for better understanding of the background of the invention and should not be taken as an acknowledgment or any form of suggestion that this information forms a prior art that would already be known to a person skilled in the art.

### Related Art Document

Patent Document 1: Korean Patent Application Publication No. 10-2013-0136259 (December 12, 2013)

### BRIEF SUMMARY OF THE INVENTION

Various aspects of the present invention provide a quantum dot composite able to improve the light efficiency of an optoelectronic device due to superior optical characteristics thereof and an optoelectronic device including the same.

In an aspect of the present invention, provided is a quantum dot composite including: a matrix layer; a number of quantum dots dispersed in the matrix layer; and a number of scattering particles dispersed in the matrix layer, the scattering particles being disposed between the quantum dots. The number of scattering particles have multiple refractive indices due to hollow spaces formed therein.

According to an embodiment of the invention, the number of scattering particles may be glass particles or polymer particles each having a hollow space therein.

The content of the number of scattering particles may range from 0.04 to 10% by weight of the quantum dot composite.

The size of the scattering particles may be greater than the size of the quantum dots.

The size of the scattering particles may range from 3 to 100 µm.

The number of the quantum dots may be formed from one nanocrystal selected from the group consisting of a silicon nanocrystal, a group II-VI compound semiconductor nanocrystal, a group III-V compound semiconductor nanocrystal, a group IV-VI compound semiconductor nanocrystal and a mixture including at least two of them.

The matrix layer may be formed from polymer resin.

In another aspect of the present invention, provided is an optoelectronic device including the above-described quantum dot composite on a path along which light enters or exits.

According to the present invention as set forth above, the number of scattering particles are dispersed in the matrix layer, have multiple refractive indices due to hollow spaces therein, and occupy the spaces between the number of quantum dots dispersed in the matrix layer such that light generated from the number of quantum dots can sufficiently radiate. The number of scattering particles are provided as a means for complicating or diversifying paths for light generated from the quantum dots, light emitted from an optoelectronic device, or light entering the optoelectronic device. Accordingly, the number of scattering particles improve the light efficiency of the optoelectronic device.

When the quantum dot composite according to the present invention is applied as a color conversion substrate for an LED, the quantum dot composite significantly improves the color conversion efficiency and luminance compared to a quantum dot composite of the related art, thereby reducing the amount of the used quantum dots compared to the related art.

### BRIEF DESCRIPTION OF THE DRAWINGS

FIG. 1 is a schematic view illustrating a quantum dot composite according to an exemplary embodiment of the present invention;
FIG. 2 and FIG. 3 are microscopic pictures of a quantum dot composite according to an exemplary embodiment of the present invention;
FIG. 4 to FIG. 8 are emission spectra of quantum dot composites according to Example 1 to Example 5 of the present invention; and
FIG. 9 is an emission spectrum of a quantum dot composite according to Comparative Example 1.

### DETAILED DESCRIPTION OF THE INVENTION

Reference will now be made in detail to embodiments of a quantum dot composite and an optoelectronic device including the same according to the present invention, which are illustrated in the accompanying drawings and described below, so that a person skilled in the art to which the present invention relates could easily put the present invention into practice.

Throughout this document, reference should be made to the drawings, in which the same reference numerals and symbols are used throughout the different drawings to designate the same or similar components. In the following description of the present invention, detailed descriptions of known functions and components incorporated herein will be omitted in the case that the subject matter of the present invention is rendered unclear.

Referring to FIG. 1 to FIG. 3, a quantum dot composite 100 according to an exemplary embodiment of the present invention is applied to an optoelectronic device to improve the light efficiency of the optoelectronic device. For example, when the optoelectronic device is implemented as an optoelectronic transmitter, such as a light-emitting diode (LED) or an organic light-emitting diode (OLED), the quantum dot composite 100 is disposed on a path along which light generated from the optoelectronic device exits in order to increase the intensity of the exiting light by scattering the light along a variety of paths while the light is passing therethrough. When the optoelectronic device is implemented as an optoelectronic receiver, such as a photoelectric cell, the quantum dot composite 100 is disposed on a path along which light enters the optoelectronic receiver in order to increase the intensity of light absorbed into the optoelectronic receiver by scattering the light along a variety of paths while the light is passing therethrough. In this manner, the quantum dot composite 100 improves the efficiency of the optoelectronic device.

In addition, the quantum dot composite 100 according to this embodiment may be in the shape of a sheet or a substrate. The quantum dot composite 100 of this shape can be applied as a member that is disposed over an LED to convert the color of part of light emitted from the LED. Specifically, an LED package including the quantum dot composite 100 according to this embodiment and an LED emits white light produced by mixing, for example, blue light from a blue LED and color-converted light from the quantum dot composite 100. Although not illustrated, the LED may include a body and an LED chip. The body is a structure having an opening of a preset shape, and provides a structural space in which the LED chip is disposed. The body is provided with wires and lead frames with which the LED chip is electrically connected to an external power source. In addition, the LED chip is a light source that emits light in response to current applied from the outside. The LED chip is mounted on the body, and is connected to the external power source through the wires and the lead frames. The LED chip may be configured as a forward junction of an n-semiconductor layer that provides electrons and a p-semiconductor layer that provides holes.

The quantum dot composite 100 according to this embodiment as described above is applied as an optical functional member for a variety of optoelectronic devices, in particular, a color conversion substrate for an LED, and includes a matrix layer 110, a number of quantum dots 120 and a number of scattering particles 130.

The matrix layer 110 serves to protect the number of quantum dots 120 and the number of scattering particles 130 dispersed therein from the external environment, such as moisture. In addition, the matrix layer 110 maintains the structure in which the number of quantum dots 120 are dispersed. The matrix layer 110 may be in the shape of a sheet or a substrate produced by machining or molding, and provides paths along which light is emitted or received. According to an embodiment of the present invention, the matrix layer 110 may be formed from a thermal or ultraviolet (UV) curable polymer resin.

The number of quantum dots 120 are dispersed inside the matrix layer 110. The matrix layer 110 protects the number of quantum dots 120 from the external environment, and maintains the number of quantum dots 120 in the dispersed state.

The number of quantum dots 120 are a nanocrystal made of semiconductor material having a diameter of about 1 to 10 nm, and exhibits quantum confinement characteristics. The quantum dots 120 generate wavelength-converted light, i.e., fluorescent light, by converting the wavelength of light emitted from the LED. For example, when the quantum dot composite 100 according to this embodiment is applied as a color conversion substrate for a blue LED, the number of quantum dots 120 generate fluorescent light by converting part of blue light generated from the blue LED into yellow light in order to produce white light through color mixing of the yellow light with the blue light from the blue LED.

The number of quantum dots 120 may be formed from one nanocrystal selected from among, but not limited to, a silicon (Si) nanocrystal, a group II-VI compound semiconductor nanocrystal, a group III-V compound semiconductor nanocrystal, a group IV-VI compound semiconductor nanocrystal and a mixture including at least two of them. For example, for the number of quantum dots 120, CdSe may be used as the group II-VI compound semiconductor nanocrystal, and InP may be used as the group III-V compound semiconductor nanocrystal. However, according to an embodiment of the present invention, the quantum dots 120 are not specifically limited to CdSe or InP.

Like the number of quantum dots 120, the number of scattering particles 130 are dispersed inside the matrix layer 110. Here, the scattering particles 130 dispersed inside the matrix layer 110 are disposed between the quantum dots 120. According to an embodiment of the present invention, the size of the scattering particles 130 is greater than the size of the quantum dots 120. For example, the size of the scattering particles may range from 3 to 100 µm, which is greater than the size of the nanocrystal quantum dots 120. The size of the scattering particles 130 may be defined as the diameter of the scattering particles 130 that are spherical.

When the scattering particles 130 are disposed between the smaller quantum dots 120, spaces for sufficient radiation of light generated from the number of quantum dots 120 are defined between the adjacent quantum dots 120 inside the matrix layer 110, thereby making it possible to realize superior color conversion efficiency and color rendering index (CRI). According to this embodiment, the scattering particles 130 contribute to the superior optical properties of the quantum dot composite 100, such as color conversion efficiency and CRI. Accordingly, the amount of the quantum dots 120 used in the quantum dot composite can be reduced compared to the related art.

The number of scattering particles 130 according to this embodiment have multiple refractive indices. For this, the number of scattering particles 130 may be glass particles or polymer particles having hollow spaces 131 therein. Here, the volume of the hollow spaces 131 within the scattering particles 130 may be about 80% of the entire volume of the scattering particles 130. Specifically, each scattering particle 130 may have a core-shell structure including a core formed of the corresponding hollow space 131 that occupies about 80% of the volume of the scattering particle and a glass or polymer shell surrounding the core. When the scattering particles 130 are formed from the glass or polymer particles each having a core-shell structure in which the core and the shell have different refractive indices, it is possible to complicate or diversify the paths of light, for example, emitted from an LED or generated from the quantum dots 120, thereby improving the extraction efficiency of light, i.e., the light efficiency of the LED.

In the case of a photoelectric cell, the scattering particles 130 can increase the intensity of light absorbed into a light-absorbing layer of the photoelectric cell by scattering incident light, thereby improving the light efficiency of the photoelectric cell.

Here, the number of scattering particles 130 can be contained inside the matrix layer 110 in a ratio ranging from 0.04 to 10% by weight of the quantum dot composite. When the content of the number of scattering particles 130 dispersed inside the matrix layer 110 is smaller than 0.04% by weight, the scattering particles 130 have an insignificant or no effect on the improvement of the color conversion efficiency. In this case, the addition of the scattering particles 130 is useless. In contrast, when the content of the number of scattering particles 130 is greater than 10% by weight, the luminance of an optoelectronic device, for example, an LED, including the quantum dot composite is lowered.

### Example 1

A first mixture was prepared by mixing quantum dots 6.6g, low-viscosity UV curable resin 2g, and high-viscosity UV curable resin 2g, and a second mixture was prepared by mixing scattering particles 2g and high-viscosity UV curable resin 10g, the scattering particles being formed from hollow glass or polymer. A quantum dot composite was manufactured by mixing the first mixture and the second mixture at a ratio of 1:0.2. Consequently, the scattering particles are dispersed in the resultant mixture, with the amount of the scattering particles being 3.08% by weight of the quantum dot composite.

### Example 2

A quantum dot composite was manufactured by mixing the first mixture and the second mixture of Example 1 at a ratio of 1:0.4. Consequently, the scattering particles are dispersed in the resultant mixture, with the amount of the scattering particles being 5.19% by weight of the quantum dot composite.

### Example 3

A quantum dot composite was manufactured by mixing the first mixture and the second mixture of Example 1 at a ratio of 1:0.6. Consequently, the scattering particles are dispersed in the resultant mixture, with the amount of the scattering particles being 6.74% by weight of the quantum dot composite.

### Example 4

A quantum dot composite was manufactured by mixing the first mixture and the second mixture of Example 1 at a ratio of 1:0.8. Consequently, the scattering particles are dispersed in the resultant mixture, with the amount of the scattering particles being 7.92% by weight of the quantum dot composite.

### Example 5

A quantum dot composite was manufactured by mixing the first mixture and the second mixture of Example 1 at a ratio of 1:1. Consequently, the scattering particles are dispersed in the resultant mixture, with the amount of the scattering particles being 8.85% by weight of the quantum dot composite.

### Comparative Example 1

A quantum dot composite was manufactured from the first mixture of Example 1. Consequently, the quantum dot composite of Comparative Example 1 was manufactured without the scattering particles that have multiple refractive indices due to hollow spaces formed therein.

**Table 1**

| | x | y | Luminance | Scattering particles (wt%) |
|---|---|---|---|---|
| Example 1 | 0.2160 | 0.2024 | 10641 | 3.08 |
| Example 2 | 0.2282 | 0.2368 | 11058 | 5.19 |
| Example 3 | 0.2409 | 0.2569 | 11368 | 6.74 |
| Example 4 | 0.2494 | 0.2659 | 11062 | 7.92 |
| Example 5 | 0.2393 | 0.2574 | 11266 | 8.85 |
| Comp. Ex. 1 | 0.1748 | 0.1117 | 7586 | - |

Table 1 above presents the chromaticity coordinates and the luminance of the quantum dot composites according to Example 1 to Example 5 and Comparative Example 1 after the quantum dot composites were applied to light-emitting diodes (LEDs). FIG. 4 to FIG. 8 are emission spectra of the quantum dot composites according to Example 1 to Example 5 of the present invention, and FIG. 9 is an emission spectrum of the quantum dot composite according to Comparative Example 1.

Referring to Table 1 and FIG. 4 to FIG. 9, it is apparent that the luminance of each quantum dot composite including the scattering particles (Example 1 to Example 5) was significantly improved than the luminance of the quantum dot composite without the scattering particles (Comparative Example 1). This explains that the scattering particles contribute in the improvement of optical properties. Here, the greatest luminance was measured when the content of the scattering particles was 6.74% by weight. In addition, the color conversion efficiency of the quantum dot composite including the scattering particles (Example 1 to Example 5) was almost two times the color conversion efficiency of the quantum dot composite without the scattering particles (Comparative Example 1).

As set forth above, the quantum dot composite 100 according to the present invention includes the number of quantum dots 120 dispersed in the matrix layer 110 and the scattering particles 130 disposed between the quantum dots 120. The scattering particles 130 having multiple refractive indices occupy the spaces between the quantum dots 120 such that light generated from the quantum dots 120 can sufficiently radiate, and scatter the light along a variety of paths. Accordingly, the quantum dot composite 100 according to the present invention can improve the light efficiency of an optoelectronic device to which the quantum dot composite 100 is applied. In particular, when the quantum dot composite 100 according to the present invention is applied as a color conversion substrate for an LED, the quantum dot composite 100 significantly improves the color conversion efficiency and luminance compared to a quantum dot composite of the related art without the scattering particles 130. Accordingly, the amount of the quantum dots 120 used in the quantum dot composite can be reduced compared to the related art.

The foregoing descriptions of specific exemplary embodiments of the present invention have been presented with respect to the drawings. They are not intended to be exhaustive or to limit the present invention to the precise forms disclosed, and obviously many modifications and variations are possible for a person having ordinary skill in the art in light of the above teachings.

It is intended therefore that the scope of the present invention not be limited to the foregoing embodiments, but be defined by the Claims appended hereto and their equivalents.

## Claims

1. A quantum dot composite comprising:
a matrix layer;
a number of quantum dots dispersed in the matrix layer; and
a number of scattering particles dispersed in the matrix layer, the scattering particles being disposed between the quantum dots,
wherein each scattering particle has a hollow space therein, thereby having multiple refractive indices.

2. The quantum dot composite according to claim 1, wherein each scattering particle comprises a glass particle or a polymer particle having a hollow space therein.

3. The quantum dot composite according to claim 1, wherein a content of the number of scattering particles ranges from 0.04 to 10% by weight of the quantum dot composite.

4. The quantum dot composite according to claim 1, wherein a size of the scattering particles is greater than a size of the quantum dots.

5. The quantum dot composite according to claim 4, wherein the size of the scattering particles ranges from 3 to 100 µm.

6. The quantum dot composite according to claim 1, wherein the matrix layer is formed from polymer resin.

7. The quantum dot composite according to claim 1, wherein the number of quantum dots comprise one selected from the group consisting of a silicon nanocrystal, a group II-VI compound semiconductor nanocrystal, a group III-V compound semiconductor nanocrystal, a group IV-VI compound semiconductor nanocrystal and a mixture including at least two of them.

8. An optoelectronic device comprising the quantum dot composite as claimed in any one of claims 1 to 7 on a path along which light enters or exits.
